(19) Europäisches Patentamt
European Patent Office
Office européen des brevets

(11) **EP 4 207 941 A1**

(12) **EUROPEAN PATENT APPLICATION**
published in accordance with Art. 153(4) EPC

(43) Date of publication:
**05.07.2023 Bulletin 2023/27**

(51) International Patent Classification (IPC):
**H05B 3/20** (2006.01)　　**H05B 3/84** (2006.01)

(21) Application number: **21861752.0**

(52) Cooperative Patent Classification (CPC):
**H05B 3/20; H05B 3/84**

(22) Date of filing: **30.08.2021**

(86) International application number:
**PCT/JP2021/031693**

(87) International publication number:
**WO 2022/045331 (03.03.2022 Gazette 2022/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.08.2020　JP 2020146006**

(71) Applicant: **Asahi Kasei Kabushiki Kaisha
Tokyo 100-0006 (JP)**

(72) Inventor: **HIDA, Sora
Tokyo 100-0006 (JP)**

(74) Representative: **dompatent von Kreisler Selting
Werner -
Partnerschaft von Patent- und Rechtsanwälten
mbB
Deichmannhaus am Dom
Bahnhofsvorplatz 1
50667 Köln (DE)**

(54) **TRANSPARENT HEATER AND DESIGN METHOD THEREFOR**

(57)　A transparent-heater designing method by an information processing device for a transparent heater comprising a transparent base material and a heater unit, the heater unit comprising a conductive pattern formed on a surface of or inside the transparent base material, the transparent-heater designing method comprising a designing step of estimating, by the information processing device, designing information DI based on a transmissivity T and a heat generation capacity C as targets of the transparent heater, the designing information DI comprising information related to thickness of a conductive thin line comprised in the conductive pattern and information related to a pattern shape PAT of the conductive pattern.

FIG. 1

**Description**

Technical Field

The present invention relates to a transparent heater and a designing method for the same.

Background Art

It has been discussed that a transparent conductive film is used as a transparent heater to adjust the temperature of a member required to have a transparent property, such as a window glass or a vehicle front glass. For example, Patent Literature 1 discloses, as such heater usage, a transparent conductive film comprising a mesh pattern constituted by a plurality of conductive thin metal lines, and discloses that the thin metal lines are provided in a wavy line shape. Patent Literature 2 discloses a transparent heater in which a plurality of heat lines are disposed in a mesh shape, and discloses that current density is controlled at intersections of the heat lines.

Citation List

Patent Literature

Patent Literature 1: Japanese Patent Laid-open No. 2012-14956
Patent Literature 2: Japanese Patent Laid-open No. 2017-98054

Summary of Invention

Technical Problem

It is a technological problem of a conventional transparent heater to achieve a transparent property and a heat generation property, and discussions have been made on a thin-line configuration with which a beam of light is unlikely to occur as in Patent Literature 1 and have been made from viewpoints of prevention of local heat generation and maintenance of current resistance as in Patent Literature 2, but no discussions have been made on a designing method by which a transparent heater that can achieve desired transparent and heat generation properties can be more easily designed.

The present invention has been made in view of the above-described problem and intended to provide a designing method by which a transparent heater that can achieve desired transparent and heat generation properties can be more easily designed, and a transparent heater designed by the method.

Solution to Problem

Specifically, the present invention is as follows.

[1] A transparent-heater designing method by an information processing device for a transparent heater comprising a transparent base material and a heater unit, the heater unit comprising a conductive pattern formed on a surface of or inside the transparent base material, the transparent-heater designing method comprising a designing step of estimating, by the information processing device, designing information DI based on a transmissivity T and a heat generation capacity C as targets of the transparent heater, the designing information DI comprising information related to thickness of a conductive thin line comprised in the conductive pattern and information related to a pattern shape PAT of the conductive pattern.

[2] The transparent-heater designing method according to [1], further comprising a step of receiving the transmissivity T and the heat generation capacity C.

[3] The transparent-heater designing method according to [1] or [2], in which the designing information DI further comprises information related to a power source capacity $E_0$ connected to the transparent heater.

[4] The transparent-heater designing method according to any one of [1] to [3], in which the designing information DI further comprises information related to thermal responsiveness of the transparent heater.

[5] The transparent-heater designing method according to any one of [1] to [4], in which the designing step of estimating the designing information DI estimates the designing information DI further based on thermal responsiveness as a target of the transparent heater.

[6] The transparent-heater designing method according to [5], further comprising a step of receiving the thermal responsiveness.

[7] The transparent-heater designing method according to [5], in which the designing step of estimating the designing information DI comprises

a step A1 of specifying combinations G11 of a thickness and a pattern shape based on the transmissivity T,
a step B1 of specifying combinations G12 of a thickness and a pattern shape from among the combinations G11 based on the heat generation capacity C, and
a step C1 of specifying a combination G13 of a thickness and a pattern shape with which the thermal responsiveness requested for the transparent heater is satisfied from among the combinations G12.

[8] The transparent-heater designing method according to [5], in which the designing step of estimating the designing information DI comprises

a step A2 of specifying combinations G21 of a thickness and a pattern shape based on the heat generation capacity C,
a step B2 of specifying combinations G22 of a thickness and a pattern shape from among the combinations G21 based on the transmissivity T, and
a step C2 of specifying a combination G23 of a thickness and a pattern shape with which the thermal responsiveness requested for the transparent heater is satisfied from among the combinations G22.

[9] The transparent-heater designing method according to [7] or [8], in which when neither the combination G13 nor G23 exists, the transmissivity T is changed and the steps A1 to C1 or A2 to C2 are executed.

[10] The transparent-heater designing method according to [7] or [8], in which when neither the combination G13 nor G23 exists, the heat generation capacity C is changed and the steps A1 to C1 or A2 to C2 are executed.

[11] The transparent-heater designing method according to [7] or [8], in which when neither the combination G13 nor G23 exists, the thermal responsiveness is changed and the steps A1 to C1 or A2 to C2 are executed.

[12] The transparent-heater designing method according to any one of [1] to [11], in which the conductive thin line has a line width $W_1$ of 10 $\mu$m or smaller.

[13] The transparent-heater designing method according to any one of [1] to [12], further comprising a display control step of controlling display of the designing information DI on a display device.

[14] The transparent-heater designing method according to [13], in which the display control step controls display of adjacent designing information DI' in addition to the designing information DI on the display device, the adjacent designing information DI' being estimated based on a transmissivity T' and a heat generation capacity C' that are adjacent to the transmissivity T and the heat generation capacity C as targets, respectively.

[15] The transparent-heater designing method according to any one of [1] to [14], further comprising a step of transmitting the designing information DI to a mask manufacturing device, a plate manufacturing device, or a conductive pattern formation device.

[16] A program configured to cause an information processing device to execute a designing method for a transparent heater comprising a transparent base material and a heater unit, the heater unit comprising a conductive pattern formed on a surface of or inside the transparent base material, the program causing the information processing device to execute a designing step of estimating designing information DI based on a transmissivity T and a heat generation capacity C as targets of the transparent heater, the designing information DI comprising information related to thickness of a conductive thin line comprised in the conductive pattern and information related to a pattern shape PAT of the conductive pattern.

[17] An information processing device configured to execute a designing method for a transparent heater comprising a transparent base material and a heater unit, the heater unit comprising a conductive pattern formed on a surface of or inside the transparent base material, the information processing device comprising a designing processing unit configured to execute a designing step of estimating designing information DI based on a transmissivity T and a heat generation capacity C as targets of the transparent heater, the designing information DI comprising information related to thickness of a conductive thin line comprised in the conductive pattern and information related to a pattern shape PAT of the conductive pattern.

[18] A mask manufacturing method, further comprising a step of manufacturing, by a mask manufacturing device, a mask based on designing information DI obtained by the transparent-heater designing method according to any one of [1] to [15].

[19] A plate manufacturing method, further comprising a step of manufacturing, by a plate manufacturing device, a plate based on designing information DI obtained by the transparent-heater designing method according to any one of [1] to [15].

[20] A transparent-heater manufacturing method, further comprising a step of forming, by a conductive pattern formation device, a conductive pattern based on designing information DI obtained by the transparent-heater designing method according to any one of [1] to [15] and manufacturing a transparent heater.

[21] A transparent heater connected to a power source of a power source capacity $E_0$, the transparent heater comprising a transparent base material and a heater unit, the heater unit comprising a conductive pattern formed on a surface of or inside the transparent base material, in which the conductive pattern has electric power consumption in a range of $\pm 30\%$ of the power source capacity $E_0$ and has a transmissivity T equal to or higher than 75%.

Advantageous Effects of Invention

According to the present invention, it is possible to provide a designing method by which a transparent heater that can achieve desired transparent and heat generation properties can be more easily designed, and a transparent heater designed by the method.

Brief Description of Drawings

[Figure 1] Figure 1 illustrates a schematic diagram of a transparent heater of the present embodiment.

[Figure 2] Figure 2 illustrates an enlarged perspective view of a range denoted by S in Figure 1.

[Figure 3] Figure 3 illustrates a block diagram of an information processing device of the present embodiment.

[Figure 4] Figure 4 illustrates a trial graph of estimation of a sheet resistance based on a transmissivity T and a film thickness.

[Figure 5] Figure 5 illustrates a flowchart of a pattern 1 of a designing step in a transparent-heater designing method of the present embodiment.

[Figure 6] Figure 6 illustrates a trial graph of estimation of the transmissivity T based on a thickness and a pattern shape.

[Figure 7] Figure 7 illustrates a trial graph of estimation of electric power consumption based on the thickness and the pattern shape.

[Figure 8] Figure 8 illustrates a flowchart of a pattern 2 of the designing step in the transparent-heater designing method of the present embodiment.

[Figure 9] Figure 9 illustrates a flowchart of a pattern 4 of the designing step in the transparent-heater designing method of the present embodiment.

[Figure 10] Figure 10 illustrates a flowchart of a pattern 5 of the designing step in the transparent-heater designing method of the present embodiment.

[Figure 11] Figure 11 illustrates a flowchart of a pattern 6 of the designing step in the transparent-heater designing method of the present embodiment.

[Figure 12] Figure 12 illustrates a flowchart of a pattern 7 of the designing step in the transparent-heater designing method of the present embodiment.

Description of Embodiment

An embodiment of the present invention (hereinafter referred to as "the present embodiment") will be described below in detail but does not limit the present invention and may be modified in various manners without departing from the scope.

1. Transparent-heater designing method

A transparent-heater designing method of the present embodiment is a designing method by an information processing device for a transparent heater comprising a transparent base material and a heater unit, the heater unit comprising a conductive pattern formed on a surface of or inside the transparent base material.

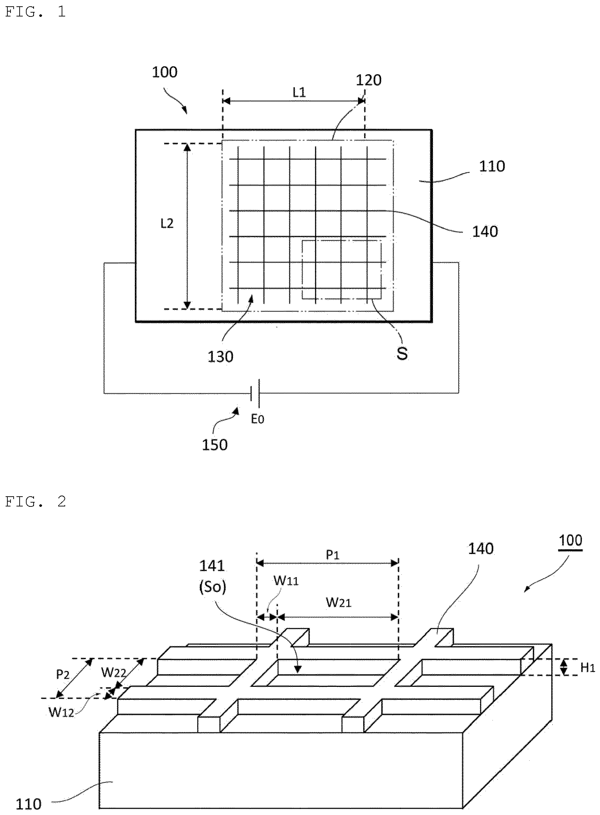

Brief description of the configuration of a designed transparent heater will be made first before description of the transparent-heater designing method. Figure 1 illustrates a top view of a transparent heater comprising a conductive pattern in a mesh shape as an aspect of a transparent heater of the present embodiment, and Figure 2 illustrates a perspective view of a region S in Figure 1. A transparent heater 100 of the present embodiment comprises a heater unit 120 comprising a conductive pattern 130 on the surface of or inside a transparent base material 110.

As illustrated in Figure 1, the conductive pattern 130 comprised in the heater unit 120 is, for example, a pattern comprising conductive thin lines 140. The conductive pattern 130 is electrically connected to a power source 150 through electrodes (not illustrated), and the conductive pattern 130 generates heat and the transparent heater 100 exerts a heater function as current flows from the power source 150 to the conductive pattern.

The conductive pattern 130 may be a grid pattern (mesh pattern) in which the conductive thin lines 140 intersect as illustrated in Figure 1 or may be a line pattern, and it is possible to control a transparent property, a heat generation capacity, or thermal responsiveness to be described later in accordance with the thickness and density of the conductive thin lines 140 thus configured. The transparent-heater designing method of the present embodiment estimates designing information that serves as a guide for the configuration of the conductive pattern 130 to obtain a desired transparent property and a desired heat generation capacity.

1.1. Hardware configuration

In the present embodiment, for example, a system is established that estimates, by an information processing device 300 that is a designing device, designing information DI based on a transmissivity T and a heat generation capacity C as targets of the transparent heater 100, the designing information DI comprising information related to the thickness of a conductive thin line comprised in the conductive pattern 130 and information related to a pattern shape PAT of the conductive pattern 130.

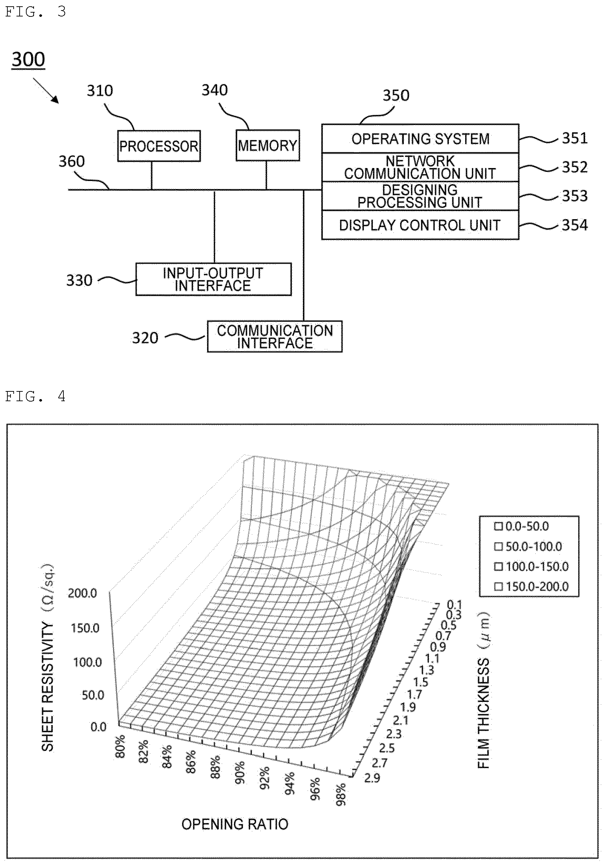

Figure 3 is a diagram illustrating an example of a hardware configuration and a functional configuration of the information processing device 300 according to the present embodiment. As illustrated in Figure 3, the information processing device 300 typically comprises one or a plurality of processors 310, a communication interface 320 configured to control wired or wireless communication, an input-output interface 330, a memory 340, a storage 350, and one or a plurality of communication buses 360 for mutually connecting these constituent components, and processing, a function, or a method described in the present disclosure is achieved by cooperation of the components.

Such a terminal is, for example, a personal computer, a touch panel, or a tablet.

Each processor 310 executes processing, a function, or a method achieved by a code or a command comprised in a program stored in the memory 340. The processor 310 comprises, not as a limitation but as an example, one or a plurality of central processing units (CPU) and graphics processing units (GPU).

The communication interface 320 transmits and receives various kinds of data to and from another information processing device through a network. This communication may be executed in any of wired and wireless manners, and any communication protocol may be used as long as communication can be executed between each other. For example, the communication interface 320 is implemented as a hardware component such as a network adapter, various communication software components, or a combination thereof.

The input-output interface 330 comprises an input device that inputs various operations on the information processing device 300, and an output device that outputs a result of processing by the information processing device 300. For example, the input-output interface 330 comprises an information input device such as a keyboard, a mouse, or a touch panel, and an information output device such as a display device.

The memory 340 temporarily stores a program loaded from the storage 350 and provides a work area to the processor 310. The memory 340 also temporarily stores various kinds of data generated while a program is executed by the processor 310. The memory 340 may be, not as a limitation but as an example, a high-speed random-access memory such as a ROM, a DRAM, an SRAM, a DDR RAM, or any other random-access solid storage device or may be a combination thereof.

The storage 350 stores programs, various kinds of functional units, and various kinds of data. The storage 350 may be, not as a limitation but as an example, a non-transitory memory such as a magnetic disk storage device, an optical disk storage device, a flash memory device, or any other non-transitory solid storage device or may be a combination thereof. Other examples of the storage 350 comprise one or a plurality of storage devices installed remotely from the processor 310.

In the present embodiment, the storage 350 stores programs, functional components, and data structures, or a subset thereof. As illustrated in Figure 3, the information processing device 300 functions as a designing processing unit 343 and a display control unit 344 as commands comprised in a program stored in the storage 350 are executed by the processor 310.

An operating system 341 processes, for example, various basic system services and comprises a procedure for executing a task by using hardware.

For example, a network communication unit 342 is used to connect the information processing device 300 to another device such as a mask manufacturing device, a plate manufacturing device, or a conductive pattern formation device through the communication interface 320 and a network and functions as a transmission-reception unit for various kinds of information.

Although specific operation processing will be described later, the designing processing unit 343 executes processing of estimating, based on the transmissivity T and the heat generation capacity C as targets of the transparent heater 100, the designing information DI comprising information related to the thickness of each conductive thin line 140 comprised in the conductive pattern 130 and information related to the pattern shape PAT of the conductive pattern 130. In this case, the designing processing unit 343 may receive information related to the transmissivity T and the heat generation capacity C as targets from a designer through the input-output interface 330.

The designing processing unit 343 may execute processing of estimating the designing information DI further comprising information related to a power source capacity $E_0$ connected to the transparent heater. Accordingly, the power source capacity $E_0$ suitable for the designed transparent heater 100 can be designated, and thus it is possible to achieve the transparent heater that can effectively exploit the power source capacity, and also it is possible to prevent connection of a power source the power source capacity $E_0$ of which is excessively large.

The information related to the power source capacity $E_0$ may additionally comprise information related to thermal responsiveness when the power source capacity $E_0$ is selected. As described later, there is a tendency that the heat generation capacity C is restricted by the power source capacity $E_0$ and the heat releasing capacity is not restricted by the power source capacity $E_0$. Thus, the thermal responsiveness of the transparent heater, for example, the ratio of the heat generation capacity C and a heat releasing capacity D (the heat generation capacity C/the heat releasing capacity D) changes in accordance with the power source capacity $E_0$. When the designing information DI comprises information related to such thermal responsiveness as the information related to the power source capacity $E_0$, the designer can immediately understand the degree of thermal responsiveness obtained when the transparent heater is connected to the power source capacity $E_0$.

The designing processing unit 343 may execute processing of estimating the designing information DI further based on thermal responsiveness as a target of the transparent heater 100. In this case, the designing processing unit 343 may receive information related to the target thermal responsiveness from the designer through the input-output interface 330. Typically, predetermined thermal responsiveness is required for a heater in accordance with the usage and purpose thereof. For example, when a heater is bonded to the surface of a camera lens and used, it is assumed that precise temperature control is required for the heater and such heat response performance that the heater is easily heated and cooled is required to finely control the temperature of the heater. In usage for preventing fog or frost generation on a window glass or a vehicle front glass, it is assumed that such heat response performance that the heater is less likely to be cooled is required for the heater to maintain generated heat after electric power supply is stopped.

However, a complicate relation exists among the transparent property, the heat generation capacity, and the heat releasing capacity of the transparent heater 100 and parameters that define the conductive pattern 130, a large number of parameters need to be adjusted to obtain the transparent heater 100 having desired thermal responsiveness, and thus designing thereof is not easy. However, when the designing method of the present embodiment is used, it is possible to relatively easily design the transparent heater 100 having desired thermal responsiveness.

The designing processing unit 343 may transmit the designing information DI to another device through the transmission-reception unit. The other device is, for example, a device that manufactures the transparent heater 100 by using the designing information DI, or a device that manufactures a member used to manufacture the transparent heater 100. More specifically, examples of the member used to manufacture the transparent heater 100 comprise a mask and a plate, and examples of the device that manufactures these members comprise a mask manufacturing device and a plate manufacturing device. The device that manufactures the transparent heater 100 by using the designing information DI is not particularly limited but is, for example, a device that manufactures the transparent heater 100 by photolithography or the like using a mask, a device that manufactures the transparent heater 100 by a plate printing method using a plate, or a device that manufactures the transparent heater 100 by an ink-jet method or the like. Note that devices that manufacture the transparent heater 100 by using the designing information DI are collectively referred to as "conductive pattern formation devices" in some cases.

For example, the designing processing unit 343 may transmit the designing information DI to both the mask manufacturing device and the device that manufactures the transparent heater 100 by a photolithography method or the like using a mask, or both the plate manufacturing device and the device that manufactures the transparent heater 100 by the plate printing method using a plate. Accordingly, information related to a planar view shape, such as a line width $W_1$ and the pattern shape PAT of the conductive pattern 130 among pieces of information comprised in the designing information DI can be used by the mask manufacturing device and the plate manufacturing device, and information related to a stereoscopic shape, such as the cross-sectional area of the conductive pattern 130 and the film thickness of each conductive thin line 140 among pieces of information comprised in the designing information DI can be used by the device that manufactures the transparent heater 100.

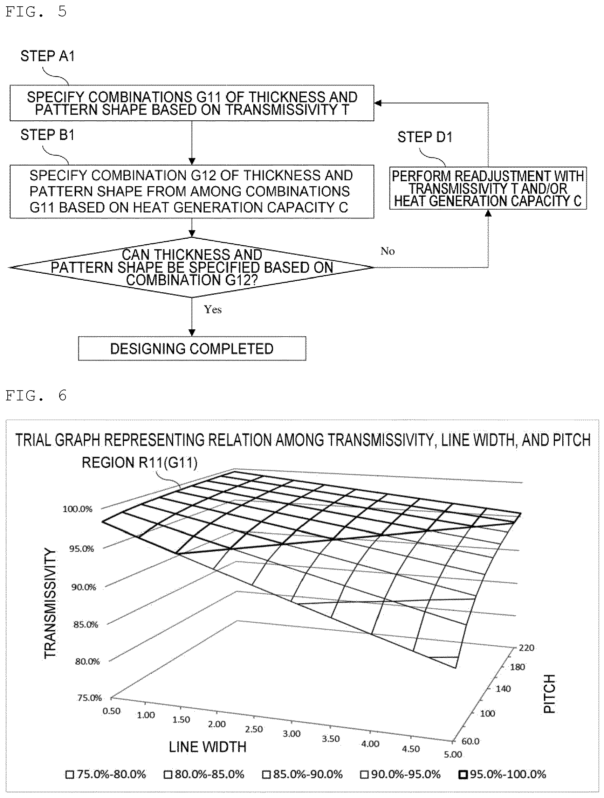

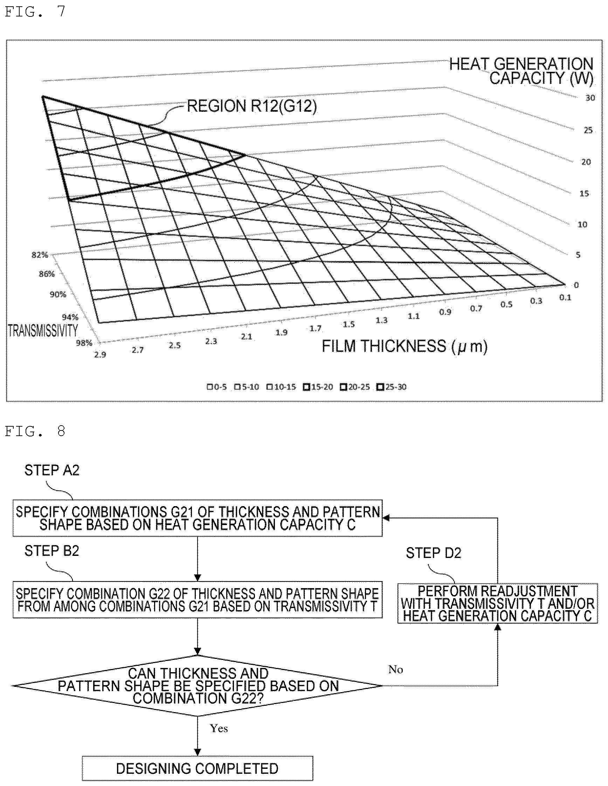

The display control unit 344 may control display of the designing information DI estimated by the designing processing unit 343 on a display device. The display control of the designing information DI is not limited to a particular aspect, but for example, information related to the thickness of each conductive thin line 140 and information related to the pattern shape PAT of the conductive pattern 130 may be displayed by text or may be displayed as two-dimensional or three-dimensional graphs as illustrated in Figures 6 and 7.

The display control unit 344 may control display of adjacent designing information DI' in addition to the designing information DI on the display device, the adjacent designing information DI' being estimated based on a transmissivity T' and a heat generation capacity C' adjacent to the transmissivity T and the heat generation capacity C as targets. For example, when the target transmissivity T is 88 to 90%, the range of "being adjacent" is a range higher or lower than the target transmissivity T, such as 86 to 88% or 90 to 92%. With the display control of the adjacent designing information DI' estimated based on the transmissivity T' and the heat generation capacity C', the designing information when the transmissivity is increased or decreased can be understood as reference information and designing can be easily performed.

The display control of the adjacent designing information DI' is not limited to a particular aspect, but for example, similarly to the designing information DI, the adjacent designing information DI' may be displayed by text or may be displayed as two-dimensional or three-dimensional graphs as illustrated in Figures 6 and 7. When controlling display of both the designing information DI and the adjacent designing information DI', the display control unit 344 may highlight the designing information DI in the display control.

1.2. Operation processing

The following describes operation of the information processing device 300 according to the embodiment of the present invention thus configured.

1.2.1. Designing processing step

Terms used in designing processing will be described before specific aspects of a designing step in which the designing processing unit 343 estimates the designing information DI is described. Note that the designing step is not limited to a particular aspect but has, for example, patterns 1 to 7 below.

Note that the "transmissivity T" in the present embodiment means the visible light transmissivity at a part where the conductive pattern 130 is formed in the transparent heater 100. Note that a value estimated based on the conductive pattern may be used as the transmissivity T in place of the actual value of the visible light transmissivity.

The line width $W_1$ of each conductive thin line 140 is preferably designed to be 10 $\mu$m or smaller. When the line width $W_1$ of each conductive thin line 140 is sufficiently small at, for example, 10 $\mu$m or smaller, visibility of the conductive thin line 140 decreases and the transparent property of the transparent heater further improves.

First, an opening ratio RO can be estimated by Expression (1) below as the ratio of the area of a part where no conductive thin line 140 is provided in the heater unit 120 having a predetermined area. Expression (1) below can be expressed by line widths $W_{11}$ and $W_{12}$, opening widths $W_{21}$ and $W_{22}$, pitches $P_1$ and $P_2$ as described below.

$$\text{The opening ratio RO (\%)} = \{(\text{the area of a part where no conductive thin line is provided in a predetermined region})/(\text{the area of the heater unit in the predetermined region})\} \times 100 \;\ldots\; (1)$$

$$= \{(W_{21} \times W_{22})/(P_1 \times P_2)\} \times 100$$

$$= \{(P_1 - W_{11}) \times (P_2 - W_{12})/(P_1 \times P_2)\} \times 100$$

The transmissivity T can be approximated by Expression (2) below by using the above-described opening ratio RO, the transmissivity of the transparent base material 110, and the transmissivity of each conductive thin line 140. Expression (2) below can be estimated by setting the transmissivity of each conductive thin line 140 to zero when it can be regarded that the conductive thin line 140 does not transmit light.

$$\text{The transmissivity } T (\%) = \{(\text{the transmissivity of}$$
$$\text{the transparent base material}) \times (\text{the opening ratio RO } (\%))$$
$$+ (\text{the transmissivity of the transparent base}$$
$$\text{material}) \times (\text{the transmissivity of the conductive thin}$$
$$\text{line}) \times (100 - \text{the opening ratio RO } (\%))\}/100 \ldots (2)$$

The transmissivity of the transparent base material and the transmissivity of the conductive thin line described above are may be those stored in advance, in accordance with a used material or the like, or may be those input from the designer through the input-output interface 330.

Note that, in the present embodiment, line widths in a case of a rectangular grid pattern as in Figures 1 and 2 are referred to as the line widths $W_{11}$ and $W_{12}$ in accordance with directions, and are simply referred to as the line width $W_1$ when not distinguished based on directions. Similarly, opening widths in a case of a rectangular grid pattern are referred to as the opening width $W_{21}$, $W_{22}$, and are simply referred to as an opening width $W_2$ when not distinguished based on directions. This is the same for a pitch P.

The "heat generation capacity C" means the heat generation capacity at the conductive pattern 130 of the transparent heater 100 and can be expressed by electric power E consumed by the conductive pattern 130.

First, a sheet resistivity Rs can be estimated based on the specific resistance of the conductive thin line and cross-sectional area Sm of the conductive thin line 140 per unit length of the heater unit 120. For example, the sheet resistivity Rs can be expressed by Expression (3) below, which is proportional to the specific resistance of the conductive thin line and inversely proportional to the cross-sectional area Sm. Thus, the sheet resistivity Rs decreases when it is designed that the cross-sectional area Sm increases.

$$\text{The sheet resistivity } Rs = \text{a coefficient } k_1 \times (\text{the}$$
$$\text{specific resistance of the conductive thin line})/(\text{the}$$
$$\text{cross-sectional area Sm of the conductive thin line per}$$
$$\text{unit length of the heater unit}) \ldots (3)$$

The coefficient $k_1$: coefficient as a collection of terms other than the specific resistance and Sm The above-described specific resistance of the conductive thin line may be that stored in advance, in accordance with a used material or the like, or may be that input from the designer through the input-output interface 330.

The sheet resistivity Rs can be obtained by estimating the cross-sectional area Sm based on a combination of the thickness of the conductive thin line and the pattern shape. For example, in a case of a rectangular grid pattern, the sheet resistivity Rs can be expressed by Expression (4) below by using the film thickness H and the opening ratio RO by approximating Sm to $W_1 \times H/P$ by using the line width $W_1$, a film thickness H, and the pitch P and rearranging $W_1/P$ as a function of the opening ratio RO by using Expression (1) of the opening ratio RO. Figure 4 illustrates an exemplary trial graph of estimation of the sheet resistivity based on the opening ratio and the film thickness.

$$\text{The sheet resistivity } Rs = \text{a coefficient } k_2 \times (\text{the}$$
$$\text{specific resistance of the conductive thin line})/(\text{the}$$
$$\text{film thickness H of the conductive thin line}) \times \{1 + (\text{the}$$
$$\text{opening ratio RO } (\%)/100)^{1/2}\}/\{1 - (\text{the opening ratio RO}$$
$$(\%)/100)\} \ldots (4)$$

The coefficient $k_2$: coefficient as a collection of terms other than those explicitly written in Expression (4)

For example, when the length and width of the heater unit 120 are represented by L1 and L2, the resistance value of the heater for estimating electric power consumption E of the heater can be estimated by Expression (5) below by using the sheet resistivity Rs. The electric power E consumed at any resistor of the conductive pattern 130 comprised in the heater unit 120 of the predetermined length L1 and the predetermined width L2 is proportional to power voltage $V_0$ and inversely proportional to the sheet resistivity Rs and thus is expressed by Expression (6) below.

$$\text{The resistance value R of the heater} = Rs{\times}L1/L2 \text{ ... (5)}$$

$$\text{The electric power E consumed at the resistor} =$$
$$V_0{}^2/R \text{ ... (6)}$$

Accordingly, with Expressions (5) and (6), the electric power consumption E can be expressed as a function of the cross-sectional area Sm as in Expression (7). Note that the cross-sectional area Sm can be estimated based on the line width $W_1$, the film thickness H, and the pitch P, and thus the electric power consumption E can be expressed as a function of the line width $W_1$, the film thickness H, and the pitch P.
The electric power E consumed at the resistor increases when it is designed that the sheet resistivity Rs decreases.

$$\text{The electric power E consumed at the resistor} = a$$
$$\text{coefficient } k_3{\times}V_0{}^2{\times}\text{the cross-sectional area Sm ... (7)}$$

The coefficient $k_3$: coefficient as a collection of terms other than $V_0$ and Sm
The "heat releasing capacity D" means the heat releasing capacity at the conductive pattern 130 of the transparent heater 100 and can be expressed by the likelihood of heat decrease of the conductive pattern 130. For example, when it is assumed that heat is released mainly through heat transfer from the conductive pattern 130 to the electrodes, the heat releasing capacity D increases in proportion to the cross-sectional area ($W_1{\times}H$) of the conductive thin line 140 and decreases in proportion to the pitch. For example, the heat releasing capacity D can be expressed by Expression (8) below.

$$\text{The heat releasing capacity D} = \text{a coefficient}$$
$$k_4{\times}\{\text{the cross-sectional area } (W_1{\times}H) \text{ of the conductive}$$
$$\text{thin line}\}/\{\text{the pitch P of the conductive thin line}\} \text{ ...}$$
$$(8)$$

The coefficient $k_4$: coefficient as a collection of terms other than those explicitly written in Expression (8)
In Expression (8), the combination of $W_{11}$ and $P_1$ or the combination of $W_{12}$ and $P_2$ may be used as the combination of $W_1$ and P in accordance with electrode disposition of the transparent heater.
The "designing information DI" comprises the information related to the thickness of each conductive thin line comprised in the conductive pattern, and the pattern shape PAT of the conductive pattern. Accordingly, the conductive pattern 130 can be formed in the predetermined pattern shape PAT with the conductive thin lines 140 of the predetermined thickness.
Examples of the information related to the thickness of each conductive thin line 140 comprise the line width $W_1$, a cross-sectional area S, the film thickness H, and an aspect ratio ($H/W_1$), and the thickness of each conductive thin line 140 can be specified by specifying two among those pieces of information. For example, the information related to the film thickness H of each conductive thin line 140 can be obtained by specifying the line width $W_1$ and the cross-sectional area S, and information of the cross-sectional area S can be obtained by estimating the line width $W_1$ and the film thickness H or by estimating the film thickness H and the aspect ratio ($H/W_1$). Hereinafter, it is assumed that when two among the line width $W_1$, the cross-sectional area S, the film thickness H, and the aspect ratio ($H/W_1$) are specified,

the other pieces of information are specified as well.

The "pattern shape PAT" comprises specific information for forming the grid pattern, such as the shape of the pattern, which is a triangle, a rectangle, a hexagon, or the like, and the pitch, opening part area So, and the opening ratio RO that define the shape.

In specific examples of the designing step to be described below, the designing method will be described with an example in which the conductive pattern 130 is a square grid pattern. In this case, a "combination of a thickness and a pattern shape" can be interpreted as a combination of a line width, a film thickness, and a pitch. However, the present embodiment is not limited to the case of the square grid pattern but may employ an optional pattern, and various trial graphs described below may be changed and used as appropriate in accordance with a used pattern.

1.2.1.1. Pattern 1

Figure 5 illustrates a flowchart of the designing step in the pattern 1. In the pattern 1, the designing step of estimating the designing information DI comprises a step A1 of specifying, by the designing processing unit 343, combinations G11 of a thickness and a pattern shape based on the transmissivity T, and a step B1 of specifying, by the designing processing unit 343, a combination G12 of a thickness and a pattern shape from among the combinations G11 based on the heat generation capacity C.

The step A1 is a step of specifying combinations G11 of a thickness and a pattern shape based on a target transmissivity T. At the step A1, the transmissivity T of the conductive pattern 130 and parameters related thereto are estimated based on a thickness and a pattern shape, and combinations G11 of a thickness and a pattern shape with which a desired transmissivity T is satisfied are specified. In this case, Expression (1) above or its rearranged expression may be used. Accordingly, the transparent heater 100 having a desired transparent property can be designed.

Figure 6 illustrates a trial graph of estimation of the transmissivity T based on a thickness and a pattern shape. This trial graph can be drawn by using Expression (2) and its rearranged expression. Combinations G11 of a thickness and a pattern shape in accordance with a target transmissivity T can be specified by using such a trial graph. For example, when the transmissivity T is set to 95% or higher, a region R11 in which the transmissivity T is satisfied is specified and combinations G11 of a line width and a pitch with which the region R11 is satisfied are specified.

The step B1 is a step of specifying a combination G12 of a thickness and a pattern shape from among the combinations G11 based on the target heat generation capacity C. At the step B1, the heat generation capacity C of the transparent heater 100 and parameters related thereto are estimated based on a thickness and a pattern shape, and a combination G12 of a thickness and a pattern shape with which a desired heat generation capacity C is satisfied is specified. In this case, Expression (6) above or its rearranged expression may be used. Accordingly, the transparent heater 100 having the desired heat generation capacity can be designed.

Figure 7 illustrates a trial graph of estimation of the heat generation capacity C of the conductive pattern 130 based on the transmissivity T and the film thickness H. This trial graph can be drawn by using Expression (6) and its rearranged expression. Combinations G12 of a thickness and a pattern shape in accordance with a target heat generation capacity can be specified by using such a trial graph. For example, when the heat generation capacity is set to 15 W or larger, a region R12 on the graph is specified and combinations of the transmissivity T and the film thickness with which the region R12 is satisfied are specified. Subsequently, the combinations G12 can be further narrowed down based on constraint conditions of transparent-heater manufacturing. Examples of the constraint conditions of transparent-heater manufacturing comprise the relation (aspect ratio) between the line width and the film thickness, and the upper limit of the line width. These constraint conditions may be those stored in advance or may be designated by the designer through the input-output interface 330. In addition, a constraint condition in accordance with designation of a transparent-heater manufacturing method may be used. For example, the line width $W_1$ is set to be smaller than 10 $\mu$m from a viewpoint of visibility of the conductive pattern, and when the manufacturing method is an inversion transfer printing method, (the film thickness H)/(the line width $W_1$) < 0.15 is used as a constraint condition of the aspect ratio. The upper and lower limits of the line width are set based on these constraint conditions. Subsequently, when a point or a region is designated on the graph in Figure 7, the transmissivity T and combinations of the line width $W_1$ and the pitch P with which the constraint conditions of transparent-heater manufacturing are satisfied are displayed based on a combination of the transmissivity T and the film thickness H corresponding to the point or region. When such display is performed, the thermal responsiveness or the like may be displayed together. G12 can be specified by receiving a selection from among the combinations. At the combination selection, designation may be received from the designer through the input-output interface 330.

In the pattern 1, when a thickness and a pattern shape can be specified with the combination G12, it is determined that designing information satisfying a desired transmissivity T and a desired heat generation capacity C is obtained, and the designing step is ended. When there are no thickness nor pattern shape that can be achieved at specification of the combination G12, loop processing that performs the steps A1 to B1 again with changed conditions may be performed (step D1).

The loop processing is, for example, processing that changes the target transmissivity T and/or the target heat generation capacity C and executes the above-described steps A1 to B1. Moreover, even when there are a thickness and a pattern shape that can be achieved with the combination G12, an optimum thickness and an optimum pattern shape may be specified by executing the above-described processing.

Furthermore, at the designing processing step, the designing processing unit 343 may execute processing of estimating the designing information DI further comprising information related to the power source capacity $E_0$ connected to the transparent heater 100. In this case, for example, the designing processing unit 343 estimates the electric power E consumed at the resistor by Expression (7) or its rearranged expression based on the thickness and the pattern shape of the combination G12 or the heat generation capacity C considered at the step B1 and comprises the information related to the power source capacity $E_0$ connected to the transparent heater 100 in the designing information DI based on the electric power E.

A method of estimating the power source capacity $E_0$ based on the electric power E is not particularly limited, but for example, can be estimated as the power source capacity $E_0$ in the range of the electric power E $\pm 30\%$ or $\pm 50\%$. Accordingly, designing with allowance is possible with the stability of the power source taken into account.

At the designing processing step, the processing of estimating, by the designing processing unit 343, the designing information DI further comprising information related to the power source capacity $E_0$ connected to the transparent heater 100 may be executed in the patterns 2 to 7 below as well.

### 1.2.1.2. Pattern 2

Figure 8 illustrates a flowchart of the designing step in the pattern 2. In the pattern 2, the designing step of estimating the designing information DI comprises a step A2 of specifying, by the designing processing unit 343, combinations G21 of a thickness and a pattern shape based on the heat generation capacity C, and a step B2 of specifying, by the designing processing unit 343, a combination G22 of a thickness and a pattern shape from among the combinations G21 based on the transmissivity T. At the step B2, the method of specifying G12 in the pattern 1 can be used as a method of specifying G22. Specifically, the pattern 2 can be processed in the same manner as the pattern 1 except that the order of steps is different from that in the pattern 1.

In the pattern 2, when a thickness and a pattern shape can be specified with the combination G22, it is determined that designing information satisfying a desired transmissivity T and a desired heat generation capacity C is obtained, and the designing step is ended. When there are no thickness nor pattern shape that can be achieved at specification of the combination G22, loop processing that performs the steps A2 to B2 again with changed conditions may be performed (step D2).

The loop processing is, for example, processing that changes the target transmissivity T and/or the target heat generation capacity C and executes the above-described steps A2 to B2. Moreover, even when there are a thickness and a pattern shape that can be achieved with the combination G22, an optimum thickness and an optimum pattern shape may be specified by executing the above-described processing.

### 1.2.1.3. Pattern 3

In the pattern 2, the designing step of estimating the designing information DI comprises a step A3 of specifying, by the designing processing unit 343, combinations G31 of a thickness and a pattern shape based on two of the transmissivity T and the heat generation capacity C.

The step A3 is not particularly limited as long as the step can specify combinations G31 of a thickness and a pattern shape based on two of the transmissivity T and the heat generation capacity C, but two graphs, for example, the pitch and the line width, having a common axis may be placed over and combinations G31 with which the transmissivity T and the heat generation capacity C (electric power consumption) are satisfied may be specified at once.

### 1.2.1.4. Pattern 4

The pattern 4 and the pattern 5 to be described later comprise a step of executing, by the designing processing unit 343, processing of estimating the designing information DI further based on thermal responsiveness as a target of the transparent heater 100.

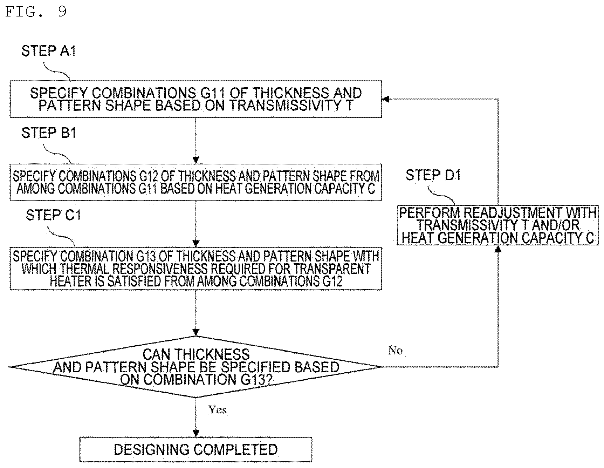

Figure 9 illustrates a flowchart of the designing step in the pattern 4. In the pattern 4, the designing step of estimating the designing information DI comprises a step A1 of specifying, by the designing processing unit 343, combinations G11 of a thickness and a pattern shape based on the transmissivity T, a step B1 of specifying, by the designing processing unit 343, combinations G12 of a thickness and a pattern shape from among the combinations G11 based on the heat generation capacity C, and a step C1 of specifying, by the designing processing unit 343, a combination G13 of a thickness and a pattern shape with which thermal responsiveness requested for the transparent heater is satisfied from among the combinations G12. The steps A1 and B1 in the pattern 4 can be processed in the same manner as in the pattern 1.

The step C1 is a step of specifying a combination G13 of a thickness and a pattern shape with which thermal responsiveness requested for the transparent heater is satisfied from among the combinations G12.

The "thermal responsiveness" is not particularly limited but is, for example, the balance between the heat generation capacity C and the heat releasing capacity D, and the transparent heater is designed to be more easily cooled as the heat releasing capacity D is higher when the heat generation capacity C is constant, whereas the transparent heater is designed to be less easily cooled as the heat releasing capacity D is lower when the heat generation capacity C is constant. Moreover, the transparent heater is designed to be more easily heated as the heat generation capacity C is higher when the heat releasing capacity D is constant, whereas the transparent heater is designed to be less easily heated as the heat generation capacity C is lower when the heat releasing capacity D is constant.

An indicator of the thermal responsiveness is not particularly limited, but examples thereof comprise the heat releasing capacity D, 1/the heat releasing capacity D, the heat generation capacity C/the heat releasing capacity D, the heat releasing capacity D/the heat generation capacity C, and the heat generation capacity C - the heat releasing capacity D.

The step C1 is a step of specifying, based on such tendencies, the combination G13 of a thickness and a pattern shape with which desired balance is obtained between the heat generation capacity C and the heat releasing capacity D.

At the step C1, for example, the heat generation capacity C expressed by Expression (6) described above or its rearranged expression and the heat releasing capacity D expressed by Expression (8) or its rearranged expression may be set, and the combination G13 may be specified so that both capacities are satisfied or the combination G13 may be specified based on the heat releasing capacity D expressed by Expression (8) or its rearranged expression since the heat generation capacity C is already considered at the step B1.

The combination G13 of a thickness and a pattern shape with which desired thermal responsiveness is satisfied may be specified by using, as one indicator, for example, the ratio (the heat generation capacity C/the heat releasing capacity D) of the heat generation capacity C expressed by Expression (6) described above or its rearranged expression and the heat releasing capacity D expressed by Expression (7) or its rearranged expression. Subsequently, the combinations G13 can be further narrowed down based on the constraint conditions of transparent-heater manufacturing. Examples of the constraint conditions of transparent-heater manufacturing comprise the relation (aspect ratio) between the line width and the film thickness, and the upper limit of the line width. These constraint conditions may be those stored in advance or may be designated by the designer through the input-output interface 330. In addition, a constraint condition in accordance with designation of a transparent-heater manufacturing method may be used. For example, the line width $W_1$ is set to be smaller than 10 $\mu$m from a viewpoint of visibility of the conductive pattern, and when the manufacturing method is the inversion transfer printing method, (the film thickness H)/(the line width $W_1$) < 0.15 is used as a constraint condition of the aspect ratio. The upper and lower limits of the line width are set based on these constraint conditions. Subsequently, when a point or a region is designated on a trial graph of estimation of the thermal responsiveness of the conductive pattern 130 based on the transmissivity T and the film thickness H, the transmissivity T and combinations of the line width $W_1$ and the pitch P with which the constraint conditions of transparent-heater manufacturing are satisfied are displayed based on a combination of the transmissivity T and the film thickness H corresponding to the point or region. When such display is performed, the thermal responsiveness or the like may be displayed together. G13 can be specified by receiving a selection from among the combinations. At the combination selection, designation may be received from the designer through the input-output interface 330.

Note that the heat generation capacity C is restricted by the power source capacity $E_0$ in reality as indicated by Expression (6), and thus there is an upper limit to be considered at part of the conductive pattern 130 of the transparent heater 100 other than designing. However, the heat releasing capacity is not related to the power source capacity $E_0$. Thus, at specification of the combination G13 of a thickness and a pattern shape of the conductive thin line 140 at the step C1, there appear the range of combinations of a thickness and a pattern shape in which the heat generation capacity and the heat releasing capacity both change, and the range of combinations of a thickness and a pattern shape in which the heat generation capacity does not further increase beyond a threshold value but the heat releasing capacity changes.

Thus, at the step C1, it is preferable to specify the combination G13 of a thickness and a pattern shape with which thermal responsiveness requested for the transparent heater is satisfied from among the combinations G12 while considering the power source capacity $E_0$.

The designing information DI related to the combination G13 thus specified preferably further comprises information related to the power source capacity $E_0$ connected to the transparent heater.

When there are no thickness nor pattern shape that can be achieved at specification of the combination G13 or when a predetermined condition is satisfied, loop processing that performs steps A1 to C1 again with changed conditions may be performed (step D1). Note that a case in which no transparent heater with which a predetermined condition is satisfied can be designed means a case in which desired thermal responsiveness is achieved by adjusting the ratio (the heat generation capacity C/the heat releasing capacity D) with the power source capacity $E_0$ taken into account at the step C1 but the heat generation capacity C is restricted because the power source capacity $E_0$ is set as described above, and as a result, the heat generation capacity at the step B1 is no longer satisfied.

These cases are, for example, processing that changes the transmissivity T or parameters related thereto and executes the steps A1 to C1, processing that changes the heat generation capacity C or parameters related thereto and executes the steps A1 to C1, and processing that changes the thermal responsiveness or parameters related thereto and executes the steps A1 to C1.

### 1.2.1.5. Pattern 5

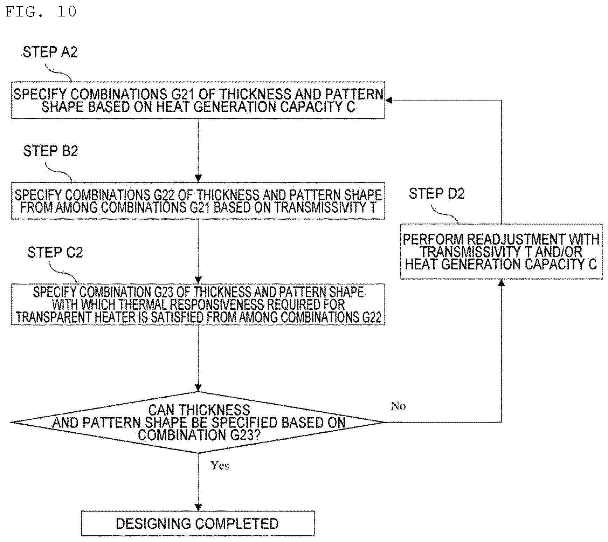

Figure 10 illustrates a flowchart of the designing step in the pattern 5. In the pattern 5, the designing step of estimating the designing information DI comprises a step A2 of specifying, by the designing processing unit 343, combinations G21 of a thickness and a pattern shape based on the heat generation capacity C, a step B2 of specifying, by the designing processing unit 343, combinations G22 of a thickness and a pattern shape from among the combinations G21 based on the transmissivity T, and a step C2 of specifying, by the designing processing unit 343, a combination G23 of a thickness and a pattern shape with which thermal responsiveness requested for the transparent heater is satisfied from among the combinations G22. The steps A2 and B2 in the pattern 5 can be processed in the same manner as in the pattern 2.

The step C2 is a step of specifying a combination G23 of a thickness and a pattern shape with which thermal responsiveness requested for the transparent heater is satisfied from among the combinations G22. The step C2 in the pattern 5 can be processed in the same manner as in the pattern 4.

When there are no thickness nor pattern shape that can be achieved at specification of the combination G23 or when a predetermined condition is satisfied, loop processing that performs steps A1 to C1 again with changed conditions may be performed (step D2). Note that a case in which no transparent heater with which a predetermined condition is satisfied can be designed means a case in which desired thermal responsiveness is achieved by adjusting the ratio (the heat generation capacity C/the heat releasing capacity D) with the power source capacity $E_0$ taken into account at the step C1 but the heat generation capacity C is restricted because the power source capacity $E_0$ is set as described above, and as a result, the heat generation capacity at the step A1 is no longer satisfied.

These cases are, for example, processing that changes the transmissivity T or parameters related thereto and executes the steps A2 to C2, processing that changes the heat generation capacity C or parameters related thereto and executes the steps A2 to C2, and processing that changes the thermal responsiveness or parameters related thereto and executes the steps A2 to C2.

### 1.2.1.6. Pattern 6

The pattern 6 is a pattern in which, instead of specifying combinations G21 based on the heat generation capacity C as a target in the pattern 5, the power source capacity $E_0$ connected to the transparent heater 100 is assumed and combinations G31 of a thickness and a pattern shape are specified by using the power source capacity $E_0$ in place of the heat generation capacity C. In the pattern 6, the heat generation capacity C is more specifically assumed as the power source capacity $E_0$, and in this meaning, the pattern 6 corresponds to a lower-level concept of the pattern 5.

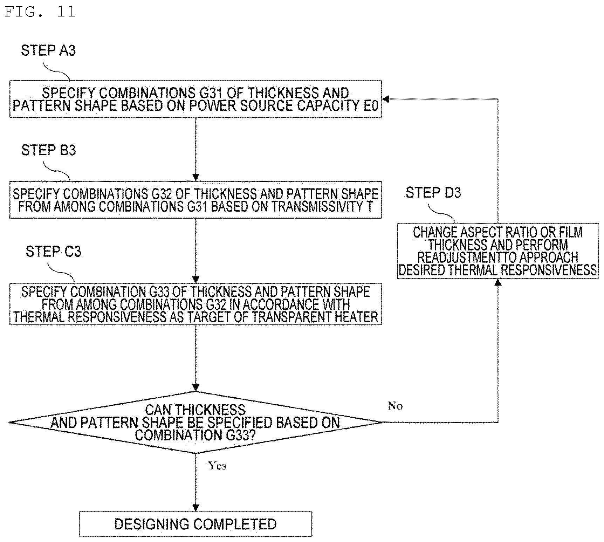

Figure 11 illustrates a flowchart of the designing step in the pattern 6. In the pattern 6, the designing step of estimating the designing information DI comprises a step A3 of specifying, by the designing processing unit 343, combinations G31 of a thickness and a pattern shape based on the power source capacity $E_0$ connected to the transparent heater 100, a step B3 of specifying, by the designing processing unit 343, combinations G32 of a thickness and a pattern shape from among the combinations G31 based on the transmissivity T, and a step C3 of specifying, by the designing processing unit 343, a combination G33 of a thickness and a pattern shape of the conductive thin line from among the combinations G32 in accordance with thermal responsiveness as a target of the transparent heater.

The step A3 is a step of specifying combinations G31 of a thickness and a pattern shape based on the power source capacity $E_0$ connected to the transparent heater. At the step A3, the electric power E consumed at the resistor of the conductive pattern 130 is estimated based on a thickness and a pattern shape, and the electric power E and the power source capacity $E_0$ are compared to specify combinations G31 of a thickness and a pattern shape with which the power source capacity $E_0$ can be effectively used. Accordingly, it is possible to specify combinations G31 of a thickness and a pattern shape with which the electric power E is not excessively larger than the power source capacity $E_0$ nor the electric power E is not excessively smaller than the power source capacity $E_0$.

Combinations G31 of a thickness and a pattern shape can be specified based on the power source capacity $E_0$ by using, for example, the trial graph as illustrated in Figure 7. For example, when the power source capacity $E_0$ is 7.5 W, the region R12 for which the electric power E is 5 to 10 W is specified and combinations G31 of a line width and a pitch with which the region R12 is satisfied are specified.

At specification of the region R12, the electric power E may have a value range such as 70 to 130%, 80 to 120%, or 90 to 110% of the power source capacity $E_0$ as a reference. When the electric power E is designed to have a width in this manner, it is easier to define a thickness and a pattern shape in accordance with thermal responsiveness at a step to be described later. Specifically, with a combination of a thickness and a pattern shape with which the electric power E exceeds the power source capacity $E_0$, the heat releasing capacity can be improved although the heat generation capacity is not improved. Moreover, with a combination of a thickness and a pattern shape with which the electric power E exceeds the power source capacity $E_0$, the transparent property can be further improved.

The step B3 is a step of specifying combinations G32 of a thickness and a pattern shape with which, for example, the transmissivity T is equal to or larger than a predetermined value from among the combinations G31. At the step B3, the transmissivity T of the conductive pattern 130 is estimated based on a thickness and a pattern shape, and combinations G32 of a thickness and a pattern shape with which a desired transmissivity T is satisfied are specified. Accordingly, the transparent heater 100 having a desired transparent property can be designed.

Combinations G32 of a thickness and a pattern shape in accordance with a target transmissivity T can be specified from among the combinations G31 by using, for example, the trial graph as illustrated in Figure 6. For example, when the transmissivity T is set to 95% or higher, a region R11 in which the transmissivity T is satisfied is specified and combinations G32 of a line width and a pitch with which the region R11 is satisfied are specified.

The step C3 is a step of specifying a combination G33 of a thickness and a pattern shape of the conductive thin line 140 from among the combinations G32 in accordance with thermal responsiveness as a target of the transparent heater. The step C2 in the pattern 5 can be processed in the same manner as in the pattern 5.

1.2.1.7. Pattern 7

The pattern 7 is a pattern in which, instead of specifying combinations G12 based on the heat generation capacity C as a target in the pattern 4, the power source capacity $E_0$ connected to the transparent heater 100 is assumed and combinations G32 of a thickness and a pattern shape are specified by using the power source capacity $E_0$ in place of the heat generation capacity C. In the pattern 7, the heat generation capacity C is more specifically assumed as the power source capacity $E_0$, and in this meaning, the pattern 7 corresponds to a lower-level concept of the pattern 4.

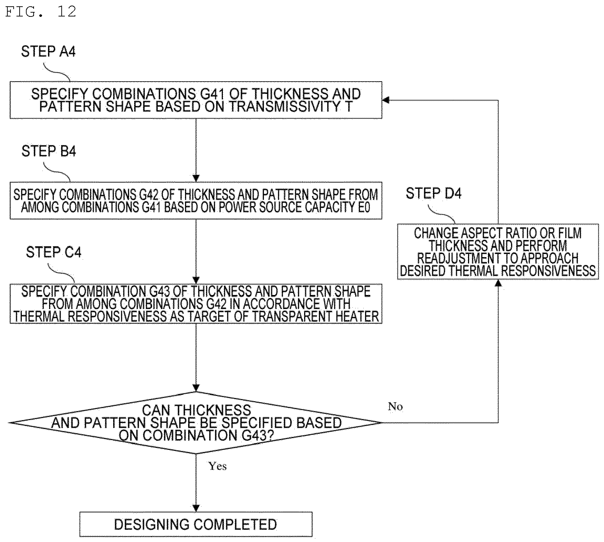

Figure 12 illustrates a flowchart of the designing step in the pattern 7. In the pattern 7, the designing step of estimating the designing information DI comprises a step A4 of specifying, by the designing processing unit 343, combinations G41 of a thickness and a pattern shape based on the transmissivity T, a step B4 of specifying, by the designing processing unit 343, combinations G42 of a thickness and a pattern shape from among the combinations G41 based on the power source capacity $E_0$ connected to the transparent heater 100, and a step C4 of specifying, by the designing processing unit 343, a combination G43 of a thickness and a pattern shape of the conductive thin line from among the combinations G42 in accordance with thermal responsiveness as a target of the transparent heater.

The step A4 is a step corresponding to the above-described step B3 and is a step of specifying combinations G41 of a thickness and a pattern shape with which, for example, the transmissivity T is equal to or larger than a predetermined value. At the step A4, the transmissivity T of the conductive pattern 130 is estimated based on a thickness and a pattern shape, and combinations G42 of a thickness and a pattern shape with which a desired transmissivity T is satisfied are specified. Accordingly, the transparent heater 100 having a desired transparent property can be designed.

The step B4 is a step corresponding to the above-described step A3 and is a step of specifying combinations G42 of a thickness and a pattern shape from among the combinations G41 based on the power source capacity $E_0$ connected to the transparent heater 100. At the step B4, the electric power E consumed at the resistor of the conductive pattern 130 is estimated based on a thickness and a pattern shape, and the electric power E and the power source capacity $E_0$ are compared to specify combinations G42 of a thickness and a pattern shape with which the power source capacity $E_0$ can be effectively used. Accordingly, it is possible to specify combinations G42 of a thickness and a pattern shape with which the electric power E is not excessively larger than the power source capacity $E_0$ nor the electric power E is not excessively smaller than the power source capacity $E_0$.

The step C4 is a step corresponding to the above-described step C3 and is a step of specifying a combination G43 of a thickness and a pattern shape of the conductive thin line 140 from among the combinations G42 in accordance with thermal responsiveness as a target of the transparent heater.

In the patterns 6 and 7, when there are no thickness nor pattern shape that can be achieved at specification of the combination G33 or G43, loop processing that performs the steps A3 to C3 or A4 to C4 again with changed conditions may be performed (step D3 or D4).

For example, the loop processing is processing that changes the aspect ratio or height of the conductive thin line comprised in the conductive pattern and executes the steps A3 to C3 or A4 to C4, processing that changes the power source capacity $E_0$ and executes the steps A3 to C3 or A4 to C4, or processing that changes the transmissivity T and executes the steps A3 to C3 or A4 to C4. Moreover, even when there are a thickness and a pattern shape that can be achieved at the combination G33 or G43, an optimum thickness and an optimum pattern shape may be specified by executing the above-described processing. As described above, according to the transparent-heater designing method, it is possible to obtain the designing information of the conductive pattern with the transparent property, the heat generation capacity, and the heat releasing capacity taken into account.

### 1.2.2. Display control step

At a display control step, the display control unit 344 executes processing that controls display of the designing information DI on the display device. The display control of the designing information DI is not limited to a particular aspect, but for example, information related to the thickness of each conductive thin line 140 and information related to the pattern shape PAT of the conductive pattern 130 may be displayed by text or may be displayed as two-dimensional or three-dimensional graphs as illustrated in Figures 6 and 7. In the case of graph display, a region representing a desired transmissivity T and/or a desired heat generation capacity C may be highlighted as illustrated in Figures 6 and 7.

Moreover, when there are no thickness nor pattern shape that can be achieved in the above-described patterns 1 to 7, the display control unit 344 may control the display device to display indicating that the designing information DI cannot be specified.

At the display control step, the display control unit 344 may control display of the adjacent designing information DI' in addition to the designing information DI on the display device, the adjacent designing information DI' being estimated based on the transmissivity T' and the heat generation capacity C' adjacent to the transmissivity T and the heat generation capacity C as targets. With the display control of the adjacent designing information DI' estimated based on the transmissivity T' and the heat generation capacity C', the designing information when the transmissivity is increased or decreased can be understood as reference information and designing can be easily performed.

### 1.2.3. Data transmission step

The designing processing unit 343 may execute a data transmission step of transmitting the designing information DI to the mask manufacturing device, the plate manufacturing device, or the conductive pattern formation device. Accordingly, manufacturing of the transparent heater can be executed by using the designing information DI.

### 1.3. Program

In the present embodiment, a program configured to cause the above-described information processing device to execute the above-described designing method, a recording medium in which the program is recorded, and an information processing device configured to execute the above-described designing method may be provided.

The information processing device of the present embodiment may be a server configured to execute the above-described designing method in accordance with a request from the terminal and transmit information related to designing of the conductive pattern to the terminal.

### 2. Mask manufacturing method

The mask manufacturing method of the present embodiment comprises a process of manufacturing, by the mask manufacturing device, a mask based on the designing information DI obtained by the above-described transparent-heater designing method. The manufactured mask may be, for example, a photomask. A specific mask manufacturing method is not particularly limited but is, for example, a method of forming a pattern on a photomask substrate based on the designing information DI by electron beam drawing or the like.

### 3. Plate manufacturing method

The plate manufacturing method of the present embodiment comprises a process of manufacturing, by the plate manufacturing device, a plate based on the designing information DI obtained by the above-described transparent-heater designing method. The plate is, for example, a flat plate or a cylinder plate. A specific plate manufacturing method is not particularly limited, but for example, a pattern based on the designing information DI may be transferred onto the plate by photolithography using the mask obtained by the above-described mask manufacturing method, or a pattern based on the designing information DI may be directly formed on the plate by electron beam drawing or the like.

### 4. Transparent-heater manufacturing method

The transparent-heater manufacturing method of the present embodiment comprises a process of forming, by the conductive pattern formation device, the conductive pattern based on the designing information DI obtained by the above-described transparent-heater designing method and manufacturing the transparent heater.

The transparent-heater manufacturing method is, for example, a method of performing plate printing of the conductive pattern on the transparent base material by using the plate obtained as described above, a method of forming the conductive pattern on the transparent base material by photolithography using the mask, or a method of forming the conductive pattern on the transparent base material by using the ink-jet method. Each method will be simply described below.

4.1. Plate printing method

The plate printing method comprises a mask manufacturing step of manufacturing, by the mask manufacturing device, a mask based on the designing information DI obtained by the above-described transparent-heater designing method, a plate manufacturing step of manufacturing, by the mask manufacturing device, a plate by using the mask, and a heater manufacturing step of forming, by the mask manufacturing device, the conductive pattern on the transparent base material by the plate printing method using the plate and manufacturing the transparent heater, and in the heater manufacturing step, the film thickness of the conductive pattern is controlled based on the designing information DI to manufacture the transparent heater.

Note that, in the plate printing method, the plate manufacturing device may directly manufacture the plate without using the mask in place of the plate manufacturing step of manufacturing the plate by using the mask. More specifically, as described above, the plate manufacturing device may produce the plate based on the designing information DI by electron beam drawing or the like.

The method of forming the conductive pattern on the transparent base material by the plate printing method is not particularly limited, but for example, ink containing metal particles is transferred onto the transparent base material by the inversion transfer printing method using the plate, and the ink transferred onto the transparent base material is sintered to form the conductive thin lines.

The film thickness of the conductive pattern can be controlled based on the designing information DI by a printing device used for the plate printing method in the heater manufacturing step. More specifically, the printing device can control the film thickness of the conductive pattern by adjusting the amount of ink applied to the plate based on the designing information DI. Moreover, in the plate manufacturing step, the film thickness of the conductive pattern can be controlled by controlling the depth of the plate based on the designing information DI.

4.2. Photolithography method

The photolithography method comprises a mask manufacturing step of manufacturing, by the mask manufacturing device, a mask based on the designing information DI obtained by the above-described transparent-heater designing method, and a heater manufacturing step of forming, by the mask manufacturing device, the conductive pattern on the transparent base material by the photolithography method using the mask and manufacturing the transparent heater, and in the heater manufacturing step, the film thickness of the conductive pattern is controlled based on the designing information DI to manufacture the transparent heater.

Note that, in the photolithography method, a metal film is uniformly formed on the transparent base material, a photosensitive material is applied thereon, the metal film at any unnecessary place is removed through development after exposure by using the above-described mask, and accordingly, the conductive thin lines are formed.

A device configured to execute the photolithography method may control the film thickness of the conductive pattern based on the designing information DI in the heater manufacturing step. More specifically, the film thickness of the conductive pattern can be controlled by controlling the thickness of the metal film, a development condition, and the like based on the designing information DI.

4.3. Ink-jet method

The ink-jet method comprises a heater manufacturing step of forming, by the printing device, the conductive pattern on the transparent base material based on the designing information DI obtained by the above-described transparent-heater designing method and manufacturing the transparent heater, and accordingly, the transparent heater is manufactured.

For example, the shape of a thin line pattern and the film thickness can be optionally adjusted by forming the conductive pattern based on the designing information DI.

5. Transparent heater

The transparent heater obtained by the designing method of the present embodiment is, for example, a transparent heater connected to a power source of the power source capacity $E_0$ and comprises a transparent base material and a heater unit comprising a conductive pattern formed on a surface of or inside the transparent base material, the conductive pattern has the electric power consumption E in the range of $\pm30\%$ of the power source capacity $E_0$, and the transmissivity T is equal to or higher than 75%. Furthermore, the visibility of the conductive pattern is preferably low, and the line width is preferably 10 $\mu$m or smaller.

In this manner, since the conductive pattern has the electric power consumption E in the range of $\pm30\%$ of the power source capacity $E_0$ and the transmissivity T is equal to or higher than 75%, the obtained transparent heater can achieve a desired transparent property, a desired heat generation capacity, and a desired heat releasing capacity and also achieve desired heat response performance.

In particular, the obtained transparent heater can have an improved heat releasing capacity when the conductive pattern has the electric power consumption E in the range of 100 to 130% of the power source capacity $E_0$, and the obtained transparent heater can have an improved heat releasing capacity when the conductive pattern has the electric power consumption E in the range of 70 to 100% of the power source capacity $E_0$. In the following, preferable ranges of parameters will be described in detail on a premise that the above-described configuration is satisfied.

### 5.1. Transparent base material

"Transparent" in the transparent base material 110 means that the visible light transmissivity is preferably equal to or higher than 80%, more preferably equal to or higher than 90%, further more preferably equal to or higher than 95%. The visible light transmissivity can be measured in compliance with JIS R 3106:1998.

The material of the transparent base material 110 is not particularly limited but is, for example, a transparent inorganic base material such as glass, or a transparent organic base material such as acrylate ester, methacrylate ester, polyethylene terephthalate, polybutylene terephthalate, polyethylene naphthalate, polycarbonate, polyarylate, polyvinyl chloride, polyethylene, polypropylene, polystyrene, nylon, aromatic polyamide, polyetheretherketone, polysulfone, polyether sulfone, polyimide, or poly ether imide. Among these materials, polyethylene terephthalate is preferable from a viewpoint of cost. Polyimide is preferable from a viewpoint of thermal resistance. Polyethylene terephthalate and polyethylene naphthalate are preferable from a viewpoint of close contact to the conductive thin lines.

The transparent base material 110 may be made of one kind of material or may be a stack of two or more kinds of material. When the transparent base material 110 is a stack of two or more kinds of material, organic base materials or inorganic base materials may be stacked or organic base materials and inorganic base materials may be stacked.

The film thickness of the transparent base material 110 is preferably 5 to 500 $\mu$m, more preferably 10 to 100 $\mu$m.

### 5.2. Heater unit

The heater unit 120 comprises the conductive pattern 130. As illustrated in Figure 1, the conductive pattern 130 comprised in the heater unit 120 is, for example, a pattern constituted by the conductive thin lines 140. The conductive pattern 130 is electrically connected to the power source 150 through the electrodes (not illustrated), and the conductive pattern 130 generates heat and the transparent heater 100 exerts a heater function as current flows from the power source 150 to the conductive pattern.

### 5.2.1. Conductive pattern

The conductive pattern 130 may be a grid pattern (mesh pattern) in which the conductive thin lines 140 intersect as illustrated in Figure 1 or may be a line pattern. The unit shape of the grid formed of the conductive thin lines 140 is not particularly limited but is, for example, a triangle, a rectangle, or a hexagon. The conductive thin lines 140 are not limited to straight lines but may be curved lines or wavy lines.

### 5.2.1.1. Pitch P

When the conductive pattern 130 is a rectangular grid pattern, the pitches $P_1$ and $P_2$ of the conductive pattern 130 are preferably 5 to 1000 $\mu$m, more preferably 50 to 500 $\mu$m, further more preferably 100 to 250 $\mu$m. When the pitches $P_1$ and $P_2$ of the conductive pattern 130 are in any of the above-described ranges, the balance among the transparent property, the heat generation capacity, and the heat releasing capacity of the heater unit 120 tends to further improve. Note that the pitch $P_1$ or $P_2$ means the sum of the line width $W_{21}$ or $W_{22}$ and the distance between the conductive thin lines 140.

Note that, when the conductive pattern 130 is a square grid pattern, the pitches $P_1$ and $P_2$ are equal, but when the conductive pattern 130 is a rectangular or rhombic grid pattern, the pitches $P_1$ and $P_2$ of the conductive thin lines 140 in two intersecting directions are preferably restricted to any of the above-described ranges.

5.2.1.2. Opening width $W_2$

When the conductive pattern 130 is a rectangular grid pattern, the opening widths $W_{21}$ and $W_{22}$ of each opening part 141 surrounded by the conductive thin lines 140 are preferably 40 to 2000 $\mu$m, more preferably 50 to 1500 $\mu$m, further more preferably 60 to 1000 $\mu$m. When the opening widths $W_{21}$ and $W_{22}$ are in any of the above-described ranges, the balance among the transparent property, the heat generation capacity, and the heat releasing capacity of the heater unit 120 tends to further improve.

Note that, when the conductive pattern 130 is a square grid pattern, the opening widths $W_{21}$ and $W_{22}$ are equal, but when the conductive pattern 130 is a rectangular or rhombic grid pattern, the opening widths $W_{21}$ and $W_{22}$ of the conductive thin lines 140 in two intersecting directions are preferably restricted to any of the above-described ranges.

5.2.1.3. Opening part area So and opening ratio OR

The conductive pattern may be expressed by using opening part area So and an opening ratio OR per opening part 141 in place of or in addition to the opening widths $W_{21}$ and $W_{22}$ and the pitches $P_1$ and $P_2$.

From the same viewpoint as that for the opening widths $W_{21}$ and $W_{22}$ and the pitches $P_1$ and $P_2$, the opening part area So is preferably 1600 $\mu$m$^2$ to 4.00 mm$^2$, more preferably 2500 $\mu$m$^2$ to 2.25 mm$^2$, further more preferably 3600 $\mu$m$^2$ to 1.00 mm$^2$. Note that, when the conductive pattern 130 has the opening parts 141 of different sizes, each opening part preferably satisfies any of the above-described ranges.

From the same viewpoint as that for the opening widths $W_{21}$ and $W_{22}$ and the pitches $P_1$ and $P_2$, the opening ratio OR is preferably 80 to 99.9 area%, more preferably 85 to 99.8 area%, further more preferably 90 to 99.6 area%, still further more preferably 95 to 99.5 area%.

5.2.2. Conductive thin line

Each conductive thin line 140 is preferably a thin line containing metal. The metal is not particularly limited but is, for example, gold, silver, copper, or aluminum. Among these metals, silver or copper is preferable, and copper is more preferable.

5.2.2.1. Line width $W_1$

The line widths $W_{11}$ and $W_{12}$ of each conductive thin line 140 are preferably 0.25 to 10 $\mu$m, more preferably 0.5 to 7.5 $\mu$m, further more preferably 1.0 to 5.0 $\mu$m. When the line widths $W_{11}$ and $W_{12}$ of each conductive thin line 140 are 10 $\mu$m or smaller, the visibility of the conductive thin line 140 decreases and the transparent property of the heater unit 120 tends to further improve. When the line widths $W_{11}$ and $W_{12}$ of each conductive thin line 140 are 0.25 $\mu$m or larger, the heat generation capacity and the heat releasing capacity tend to further improve. In particular, the heat releasing capacity tends to become larger than the heat generation capacity as the line widths $W_{11}$ and $W_{12}$ of each conductive thin line 140 increase.

5.2.2.2. Film thickness H

The film thickness H of each conductive thin line 140 is preferably 12.5 to 10000 nm, more preferably 40 to 6750 nm, further more preferably 100 to 4000 nm. When the film thickness H of each conductive thin line 140 is equal to or smaller than 1000 nm, the visibility tends to decrease at a wide view angle. When the film thickness H of each conductive thin line 140 is equal to or larger than 10 nm, the heat generation capacity and the heat releasing capacity tend to further improve. In particular, the heat releasing capacity tends to become larger than the heat generation capacity as the film thickness H of each conductive thin line 140 increases.

5.2.2.3. Aspect ratio

The aspect ratio ($H/W_1$) expressed by the film thickness H relative to the line width $W_1$ of each conductive thin line 140 is preferably 0.05 to 1.00, more preferably 0.08 to 0.90, further more preferably 0.10 to 0.80. When the aspect ratio of each conductive thin line 140 is in any of the above-described ranges, the balance among the transparent property, the heat generation capacity, and the heat releasing capacity of the heater unit 120 tends to further improve.

5.3. Transmittance T

The transmissivity T of the heater unit 120 is preferably 75 to 99.9%, more preferably 80 to 99.8%, further more preferably 85 to 99.6%, still further more preferably 90 to 99.5%. The transmissivity in the present embodiment means the visible light transmissivity and can be measured by estimating the transmissivity in the range of visible light (360 to 830 nm) in compliance with the total light transmissivity of JIS K 7361-1:1997.

The transmissivity T of the heater unit 120 tends to further improve as the line width of the conductive pattern 130 is reduced or the opening ratio is improved.

5.4. Sheet resistivity Rs

The sheet resistivity Rs of the conductive pattern 130 is preferably 0.1 to 1000 $\Omega$/sq, more preferably 0.1 to 500 $\Omega$/sq, further more preferably 0.1 to 300 $\Omega$/sq, still further more preferably 0.1 to 200 $\Omega$/sq, still further more preferably 0.1 to 100 $\Omega$/sq, still further more preferably 0.1 to 20 $\Omega$/sq, still further more preferably 0.1 to 10 $\Omega$/sq. When the sheet resistivity Rs is in any of the above-described ranges, the balance between the heat generation capacity and the heat releasing capacity of the heater unit 120 tends to further improve.

In a method of measuring the sheet resistivity, first, a part where the conductive pattern 130 is disposed on the entire surface is cut in a rectangular shape out of the heater unit 120 to obtain a measurement sample. The sheet resistivity Rs ($\Omega$/sq) can be measured from the obtained measurement sample by a four-terminal method compliant with JIS K 7194:1994. A resistivity meter used to measure the sheet resistivity is, for example, "Loresta GP" (product name; manufactured by Mitsubishi Chemical Corporation).

The sheet resistivity Rs tends to decrease as the aspect ratio (film thickness) increases even at the same occupation area rate of the conductive thin lines. The sheet resistivity Rs can be adjusted through selection of the kind of a metallic material of which the conductive thin lines are made.

[Examples]

The present invention will be more specifically described below by using examples and a comparative example. The present invention is not limited by the examples below.

Trial graph data as exemplarily illustrated in Figures 6 and 7 was established, and a program that can process the steps of the designing method illustrated in Figure 10 was produced and installed on a personal computer.

Then, premise conditions described below were set and a transparent heater of the A4 size (297 mm $\times$ 210 mm) comprising a square grid pattern as the conductive pattern was designed.

[Premise conditions]

Transparent base material: polyethylene terephthalate film

Unit length: 1 mm (1 mm square)
Thickness: 50 $\mu$m
Density: 1380 kg/m$^3$
Specific heat: 115 J/(kg·K)
Thermal conductivity: 0.33 W/(m·K)
Conductive thin line: copper
Unit length: 1 mm (1 mm square)
Aspect ratio: 0.15 $\mu$m
Density: 8880 kg/m$^3$
Specific heat: 386 J/(kg·K)
Thermal conductivity: 398 W/(m·K)
Specific resistance: 4.5 $\mu\Omega$·cm
Power source:

Power voltage: 5 V
Power source capacity: 5 W
Heating test conditions
Start temperature: 20°C
Reached temperature: 60°C

[Reference example]

First, to obtain correct answer data, information of line widths and pitches listed in Table 1 below was provided as a reference example, the opening ratio RO and the transmissivity T were estimated, the sheet resistivity based on the trial graph data and the electric power E consumed at the resistor were output, and the heat generation capacity of the heater was estimated based on the power source capacity $E_0$ and the electric power E. Results are listed in Table 1.

[Table 1]

| | Line width | Pitch | Opening ratio | Transmissivity | Sheet resistivity | A4 resistance value | Electric power consumed at resistor | Heat generation capacity of Heater |
|---|---|---|---|---|---|---|---|---|
| | w [μm] | P [μm] | X | T.T | [Ω/□] | [Ω] | [W] | [W] |
| Example 1 | 1.00 | 60 | 0.97 | 0.89 | 18.00 | 25.46 | 0.98 | 0.98 |
| Example 2 | 2.00 | 60 | 0.93 | 0.86 | 4.50 | 6.36 | 3.93 | 3.93 |
| Example 3 | 3.00 | 60 | 0.90 | 0.83 | 2.00 | 2.83 | 8.84 | 5.00 |
| Example 4 | 5.00 | 150 | 0.93 | 0.86 | 1.80 | 2.55 | 9.82 | 5.00 |
| Example 5 | 3.00 | 80 | 0.93 | 0.85 | 2.67 | 3.77 | 6.63 | 5.00 |
| Example 6 | 8.00 | 100 | 0.85 | 0.78 | 0.47 | 0.66 | 37.71 | 5.00 |
| Example 7 | 1.00 | 99.5 | 0.98 | 0.90 | 29.85 | 42.22 | 0.59 | 0.59 |
| Example 8 | 0.25 | 6 | 0.92 | 0.84 | 28.80 | 40.73 | 0.61 | 0.61 |
| Example 9 | 3.00 | 60 | 0.90 | 0.83 | 2.00 | 2.83 | 8.84 | 5.00 |
| Example 10 | 3.00 | 100 | 0.94 | 0.87 | 3.33 | 4.71 | 5.30 | 5.00 |
| Example 11 | 5.00 | 100 | 0.90 | 0.83 | 1.20 | 1.70 | 14.73 | 5.00 |
| Example 12 | 2.00 | 25 | 0.85 | 0.78 | 1.88 | 2.65 | 9.43 | 5.00 |
| Example 13 | 4.00 | 100 | 0.92 | 0.85 | 1.88 | 2.65 | 9.43 | 5.00 |
| Example 14 | 3.00 | 25 | 0.77 | 0.71 | 0.83 | 1.18 | 21.21 | 5.00 |
| Example 15 | 3.00 | 250 | 0.98 | 0.90 | 8.33 | 11.79 | 2.12 | 2.12 |
| Example 16 | 5.00 | 25 | 0.64 | 0.59 | 0.30 | 0.42 | 58.92 | 5.00 |
| Example 17 | 3.00 | 50 | 0.88 | 0.81 | 1.67 | 2.36 | 10.61 | 5.00 |

Table 2 below lists results of estimating the heat capacity of the transparent heater when configured as a transparent heater of the A4 size (297 mm × 210 mm) and the amount of heat necessary for temperature increase and estimating a temperature increase time based on the heat generation capacity of the heater.

[Table 2]

|  | Heat capacity | Amount of heat necessary for temperature increase | Heat generation capacity of Heater | Temperature increase time |
|---|---|---|---|---|
|  | [J/K] | [J] | [W] | [S] |
| Example 1 | 0.50 | 19.84 | 0.98 | 20.20 |
| Example 2 | 0.50 | 19.97 | 3.93 | 5.08 |
| Example 3 | 0.50 | 20.18 | 5.00 | 4.04 |
| Example 4 | 0.51 | 20.22 | 5.00 | 4.04 |
| Example 5 | 0.50 | 20.08 | 5.00 | 4.02 |
| Example 6 | 0.54 | 21.44 | 5.00 | 4.29 |
| Example 7 | 0.50 | 19.82 | 0.59 | 33.47 |
| Example 8 | 0.50 | 19.82 | 0.61 | 32.30 |
| Example 9 | 0.50 | 20.18 | 5.00 | 4.04 |
| Example 10 | 0.50 | 20.03 | 5.00 | 4.01 |
| Example 11 | 0.51 | 20.44 | 5.00 | 4.09 |
| Example 12 | 0.51 | 20.21 | 5.00 | 4.04 |
| Example 13 | 0.51 | 20.21 | 5.00 | 4.04 |
| Example 14 | 0.52 | 20.72 | 5.00 | 4.14 |
| Example 15 | 0.50 | 19.89 | 2.12 | 9.38 |
| Example 16 | 0.56 | 22.36 | 5.00 | 4.47 |
| Example 17 | 0.51 | 20.26 | 5.00 | 4.05 |

[Examples]

Subsequently, without consulting the data obtained in the above-described reference example, specification of a line width and a pitch were executed based on desired thermal responsiveness (temperature increase time) and the transmissivity T by using the program that can process the steps of the designing method illustrated in Figure 10.
First, the designing processing was performed to design a transparent heater having thermal responsiveness with the temperature increase time of 4.5 seconds or shorter and a transparent property with the transmissivity of 85% or higher. As a result, combinations G33 of a thickness and a pattern shape, comprising examples 4, 5, 10, and 13 were specified.

Industrial Applicability

A transparent heater of the present invention has industrial applicability as a heater bonded to a target having a transparent property or a heater that does not impair design of a non-bonding target.

Reference Signs List

100    transparent heater
110    transparent base material
120    heater unit
130    conductive pattern
140    conductive thin line
141    opening part
150    power source

| | |
|---|---|
| 300 | information processing device |
| 310 | processor |
| 320 | communication interface |
| 330 | input-output interface |
| 340 | memory |
| 341 | operating system |
| 342 | network communication unit |
| 343 | designing processing unit |
| 344 | display control unit |
| 350 | storage |
| 360 | communication bus |

**Claims**

1. A transparent-heater designing method by an information processing device for a transparent heater comprising a transparent base material and a heater unit, the heater unit comprising a conductive pattern formed on a surface of or inside the transparent base material,
the transparent-heater designing method comprising a designing step of estimating, by the information processing device, designing information DI based on a transmissivity T and a heat generation capacity C as targets of the transparent heater, wherein the designing information DI comprising information related to thickness of a conductive thin line comprised in the conductive pattern and information related to a pattern shape PAT of the conductive pattern.

2. The transparent-heater designing method according to claim 1, further comprising a step of receiving the transmissivity T and the heat generation capacity C.

3. The transparent-heater designing method according to claim 1 or 2, wherein the designing information DI further comprises information related to a power source capacity $E_0$ connected to the transparent heater.

4. The transparent-heater designing method according to any one of claims 1 to 3, wherein the designing information DI further comprises information related to thermal responsiveness of the transparent heater.

5. The transparent-heater designing method according to any one of claims 1 to 4, wherein the designing step of estimating the designing information DI estimates the designing information DI further based on thermal responsiveness as a target of the transparent heater.

6. The transparent-heater designing method according to claim 5, further comprising a step of receiving the thermal responsiveness.

7. The transparent-heater designing method according to claim 5, wherein the designing step of estimating the designing information DI comprises

   a step A1 of specifying combinations G11 of a thickness and a pattern shape based on the transmissivity T,
   a step B1 of specifying combinations G12 of a thickness and a pattern shape from among the combinations G11 based on the heat generation capacity C, and
   a step C1 of specifying a combination G13 of a thickness and a pattern shape with which the thermal responsiveness requested for the transparent heater is satisfied from among the combinations G12.

8. The transparent-heater designing method according to claim 5, wherein the designing step of estimating the designing information DI comprises

   a step A2 of specifying combinations G21 of a thickness and a pattern shape based on the heat generation capacity C,
   a step B2 of specifying combinations G22 of a thickness and a pattern shape from among the combinations G21 based on the transmissivity T, and
   a step C2 of specifying a combination G23 of a thickness and a pattern shape with which the thermal responsiveness requested for the transparent heater is satisfied from among the combinations G22.

9. The transparent-heater designing method according to claim 7 or 8, wherein when neither the combination G13 nor G23 exists, the transmissivity T is changed and the steps A1 to C1 or A2 to C2 are executed.

10. The transparent-heater designing method according to claim 7 or 8, wherein when neither the combination G13 nor G23 exists, the heat generation capacity C is changed and the steps A1 to C1 or A2 to C2 are executed.

11. The transparent-heater designing method according to claim 7 or 8, wherein when neither the combination G13 nor G23 exists, the thermal responsiveness is changed and the steps A1 to C1 or A2 to C2 are executed.

12. The transparent-heater designing method according to any one of claims 1 to 11, wherein the conductive thin line has a line width $W_1$ of 10 $\mu$m or smaller.

13. The transparent-heater designing method according to any one of claims 1 to 12, further comprising a display control step of controlling display of the designing information DI on a display device.

14. The transparent-heater designing method according to claim 13, wherein the display control step controls display of adjacent designing information DI' in addition to the designing information DI on the display device, the adjacent designing information DI' being estimated based on a transmissivity T' and a heat generation capacity C' that are adjacent to the transmissivity T and the heat generation capacity C as targets, respectively.

15. The transparent-heater designing method according to any one of claims 1 to 14, further comprising a step of transmitting the designing information DI to a mask manufacturing device, a plate manufacturing device, or a conductive pattern formation device.

16. A program configured to cause an information processing device to execute a designing method for a transparent heater comprising a transparent base material and a heater unit, the heater unit comprising a conductive pattern formed on a surface of or inside the transparent base material, the program causing the information processing device to execute a designing step of estimating, based on a transmissivity T and a heat generation capacity C as targets of the transparent heater, designing information DI comprising information related to thickness of a conductive thin line comprised in the conductive pattern and information related to a pattern shape PAT of the conductive pattern.

17. An information processing device configured to execute a designing method for a transparent heater comprising a transparent base material and a heater unit, the heater unit comprising a conductive pattern formed on a surface of or inside the transparent base material, the information processing device comprising a designing processing unit configured to execute a designing step of estimating, based on a transmissivity T and a heat generation capacity C as targets of the transparent heater, designing information DI comprising information related to thickness of a conductive thin line comprised in the conductive pattern and information related to a pattern shape PAT of the conductive pattern.

18. A mask manufacturing method, further comprising a step of manufacturing, by a mask manufacturing device, a mask based on designing information DI obtained by the transparent-heater designing method according to any one of claims 1 to 15.

19. A plate manufacturing method, further comprising a step of manufacturing, by a plate manufacturing device, a plate based on designing information DI obtained by the transparent-heater designing method according to any one of claims 1 to 15.

20. A transparent-heater manufacturing method, further comprising a step of forming, by a conductive pattern formation device, a conductive pattern based on designing information DI obtained by the transparent-heater designing method according to any one of claims 1 to 15 and manufacturing a transparent heater.

21. A transparent heater connected to a power source of a power source capacity $E_0$, the transparent heater comprising a transparent base material and a heater unit having a conductive pattern formed on a surface of or inside the transparent base material, wherein the conductive pattern has electric power consumption in a range of $\pm$30% of the power source capacity $E_0$ and has a transmissivity T equal to or higher than 75%.

FIG. 1

FIG. 2

FIG. 3

**300**

```
        310            340                    350
  PROCESSOR        MEMORY      ┌─────────────────────────┐
                              │    OPERATING SYSTEM      │──351
 360                          ├─────────────────────────┤
                              │       NETWORK           │──352
                              │  COMMUNICATION UNIT      │
                              ├─────────────────────────┤
                              │       DESIGNING         │──353
                              │   PROCESSING UNIT        │
                              ├─────────────────────────┤
                              │  DISPLAY CONTROL UNIT    │──354
                              └─────────────────────────┘

        330      INPUT-OUTPUT
                  INTERFACE

        320      COMMUNICATION
                   INTERFACE
```

FIG. 4

Legend: 0.0-50.0, 50.0-100.0, 100.0-150.0, 150.0-200.0

SHEET RESISTIVITY ($\Omega$/sq.): 200.0, 150.0, 100.0, 50.0, 0.0

OPENING RATIO: 80%, 82%, 84%, 86%, 88%, 90%, 92%, 94%, 96%, 98%

FILM THICKNESS ($\mu$m): 0.1, 0.3, 0.5, 0.7, 0.9, 1.1, 1.3, 1.5, 1.7, 1.9, 2.1, 2.3, 2.5, 2.7, 2.9

FIG. 5

STEP A1

SPECIFY COMBINATIONS G11 OF THICKNESS AND
PATTERN SHAPE BASED ON TRANSMISSIVITY T

STEP B1

STEP D1

SPECIFY COMBINATION G12 OF THICKNESS AND
PATTERN SHAPE FROM AMONG COMBINATIONS
G11 BASED ON HEAT GENERATION CAPACITY C

PERFORM READJUSTMENT WITH
TRANSMISSIVITY T AND/OR
HEAT GENERATION CAPACITY C

CAN THICKNESS AND
PATTERN SHAPE BE SPECIFIED BASED ON
COMBINATION G12?

No

Yes

DESIGNING COMPLETED

FIG. 6

TRIAL GRAPH REPRESENTING RELATION AMONG TRANSMISSIVITY, LINE WIDTH, AND PITCH

REGION R11(G11)

TRANSMISSIVITY

100.0%
95.0%
90.0%
85.0%
80.0%
75.0%

PITCH

220
180
140
100
60.0

LINE WIDTH

0.50  1.00  1.50  2.00  2.50  3.00  3.50  4.00  4.50  5.00

□ 75.0%-80.0%    □ 80.0%-85.0%    □ 85.0%-90.0%    □ 90.0%-95.0%    ■ 95.0%-100.0%

FIG. 7

FIG. 8

STEP A2

SPECIFY COMBINATIONS G21 OF THICKNESS AND PATTERN
SHAPE BASED ON HEAT GENERATION CAPACITY C

STEP B2

SPECIFY COMBINATION G22 OF THICKNESS AND PATTERN SHAPE
FROM AMONG COMBINATIONS G21 BASED ON TRANSMISSIVITY T

STEP D2

PERFORM READJUSTMENT
WITH TRANSMISSIVITY T AND/OR
HEAT GENERATION CAPACITY C

CAN THICKNESS AND
PATTERN SHAPE BE SPECIFIED BASED ON
COMBINATION G22?

No

Yes

DESIGNING COMPLETED

FIG. 9

STEP A1

SPECIFY COMBINATIONS G11 OF THICKNESS AND
PATTERN SHAPE BASED ON TRANSMISSIVITY T

STEP B1

SPECIFY COMBINATIONS G12 OF THICKNESS AND PATTERN SHAPE FROM
AMONG COMBINATIONS G11 BASED ON HEAT GENERATION CAPACITY C

STEP C1

SPECIFY COMBINATION G13 OF THICKNESS AND PATTERN SHAPE WITH
WHICH THERMAL RESPONSIVENESS REQUIRED FOR TRANSPARENT
HEATER IS SATISFIED FROM AMONG COMBINATIONS G12

STEP D1

PERFORM READJUSTMENT WITH
TRANSMISSIVITY T AND/OR
HEAT GENERATION CAPACITY C

CAN THICKNESS
AND PATTERN SHAPE BE SPECIFIED BASED
ON COMBINATION G13?

No

Yes

DESIGNING COMPLETED

FIG. 10

STEP A2

SPECIFY COMBINATIONS G21 OF THICKNESS AND PATTERN
SHAPE BASED ON HEAT GENERATION CAPACITY C

STEP B2

SPECIFY COMBINATIONS G22 OF THICKNESS AND PATTERN SHAPE
FROM AMONG COMBINATIONS G21 BASED ON TRANSMISSIVITY T

STEP D2

PERFORM READJUSTMENT WITH
TRANSMISSIVITY T AND/OR
HEAT GENERATION CAPACITY C

STEP C2

SPECIFY COMBINATION G23 OF THICKNESS AND PATTERN SHAPE
WITH WHICH THERMAL RESPONSIVENESS REQUIRED FOR
TRANSPARENT HEATER IS SATISFIED FROM AMONG COMBINATIONS G22

CAN THICKNESS
AND PATTERN SHAPE BE SPECIFIED BASED ON
COMBINATION G23?

No

Yes

DESIGNING COMPLETED

FIG. 11

STEP A3

SPECIFY COMBINATIONS G31 OF THICKNESS AND
PATTERN SHAPE BASED ON POWER SOURCE CAPACITY E0

STEP B3

SPECIFY COMBINATIONS G32 OF THICKNESS AND PATTERN SHAPE
FROM AMONG COMBINATIONS G31 BASED ON TRANSMISSIVITY T

STEP D3

CHANGE ASPECT RATIO OR FILM
THICKNESS AND PERFORM
READJUSTMENTTO APPROACH
DESIRED THERMAL RESPONSIVENESS

STEP C3

SPECIFY COMBINATION G33 OF THICKNESS AND PATTERN SHAPE
FROM AMONG COMBINATIONS G32 IN ACCORDANCE WITH
THERMAL RESPONSIVENESS AS TARGET OF TRANSPARENT HEATER

CAN THICKNESS
AND PATTERN SHAPE BE SPECIFIED BASED ON
COMBINATION G33?

No

Yes

DESIGNING COMPLETED

FIG. 12

STEP A4

SPECIFY COMBINATIONS G41 OF THICKNESS AND
PATTERN SHAPE BASED ON TRANSMISSIVITY T

STEP B4

SPECIFY COMBINATIONS G42 OF THICKNESS AND PATTERN SHAPE FROM
AMONG COMBINATIONS G41 BASED ON POWER SOURCE CAPACITY E0

STEP D4

CHANGE ASPECT RATIO OR FILM
THICKNESS AND PERFORM
READJUSTMENT TO APPROACH
DESIRED THERMAL RESPONSIVENESS

STEP C4

SPECIFY COMBINATION G43 OF THICKNESS AND PATTERN SHAPE
FROM AMONG COMBINATIONS G42 IN ACCORDANCE WITH
THERMAL RESPONSIVENESS AS TARGET OF TRANSPARENT HEATER

CAN THICKNESS
AND PATTERN SHAPE BE SPECIFIED BASED
ON COMBINATION G43?

No

Yes

DESIGNING COMPLETED

## INTERNATIONAL SEARCH REPORT

| International application No. |
| --- |
| **PCT/JP2021/031693** |

**A.      CLASSIFICATION OF SUBJECT MATTER**

*H05B 3/20*(2006.01)i; *H05B 3/84*(2006.01)i
FI:    H05B3/84; H05B3/20 337

According to International Patent Classification (IPC) or to both national classification and IPC

**B.      FIELDS SEARCHED**

Minimum documentation searched (classification system followed by classification symbols)

H05B3/20; H05B3/84

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.      DOCUMENTS CONSIDERED TO BE RELEVANT**

| Category* | Citation of document, with indication, where appropriate, of the relevant passages | Relevant to claim No. |
| --- | --- | --- |
| Y | JP 2010-251230 A (FUJIFILM CORP.) 04 November 2010 (2010-11-04) paragraphs [0036], [0053], [0072]-[0084], fig. 1 | 1-6, 12-21 |
| A | | 7-11 |
| Y | JP 2014-218103 A (RENIAS KK) 20 November 2014 (2014-11-20) paragraphs [0016]-[0017] | 1-6, 12-21 |
| Y | JP 2017-212047 A (DAINIPPON PRINTING CO., LTD.) 30 November 2017 (2017-11-30) paragraph [0008] | 3-6, 12-15, 18-21 |
| Y | JP 2008-123784 A (KITAGAWA INDUSTRIES CO., LTD.) 29 May 2008 (2008-05-29) paragraph [0007] | 3-6, 12-15, 18-21 |

☐ Further documents are listed in the continuation of Box C.      ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **27 September 2021** | **05 October 2021** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2021/031693**

| Patent document cited in search report | | | Publication date (day/month/year) | Patent family member(s) | Publication date (day/month/year) |
|---|---|---|---|---|---|
| JP | 2010-251230 | A | 04 November 2010 | (Family: none) | |
| JP | 2014-218103 | A | 20 November 2014 | (Family: none) | |
| JP | 2017-212047 | A | 30 November 2017 | (Family: none) | |
| JP | 2008-123784 | A | 29 May 2008 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012014956 A

- JP 2017098054 A